# EUROPEAN PATENT APPLICATION

(11) **EP 4 404 694 A1**
(43) Date of publication of application: **24.07.2024**
(21) Application number: 22878476.5
(22) Date of filing: 03.10.2022
(51) Int. Cl.: H05H 1/24

(54) **ELECTRIC DISCHARGE DEVICE, REFRIGERANT ASSESSMENT DEVICE, AND REFRIGERANT ASSESSMENT METHOD**

(30) Priority: 07.10.2021 JP 2021165369
(71) Applicant: Daikin Industries, Ltd., Osaka-shi, Osaka 530-0001 (JP)
(72) Inventor: USUI, Takashi, Osaka-shi, Osaka 530-0001 (JP); GOTO, Tomoyuki, Osaka-shi, Osaka 530-0001 (JP); OSHIME, Yasuhiro, Osaka-shi, Osaka 530-0001 (JP); YOSHIMURA, Takashi, Osaka-shi, Osaka 530-0001 (JP)
(74) Representative: Hoffmann Eitle
(86) International application number: PCT/JP2022/037000
(87) International publication number: WO 2023/058607

(57) **Abstract**

A discharging device (20) includes a first electrode (71) and a second electrode (72), a capacitor (31), and a reactor unit (40). The first electrode (71) and the second electrode (72) are separated from each other. The capacitor (31) stores energy (E) to apply a first voltage (V₁) between the first electrode (71) and the second electrode (72). The reactor unit (40) includes a first reactor (50) and a second reactor (60). The reactor unit (40) inductively generates a second voltage (V₂) to be applied between the first electrode (71) and the second electrode (72) to start discharge of the energy (E) between the first electrode (72) and the second electrode (72).

## Description

### Technical Field

The present disclosure relates to a discharging device used for determining the likelihood of occurrence of a disproportionation reaction in a refrigerant. The present disclosure further relates to a refrigerant evaluation device and a refrigerant evaluation method using such a discharging device.

### Background Art

Non-Patent Document 1 (Japanese Industrial Standard (JIS) Z 8834) discloses a method for determining minimum ignition energy of dust/air mixtures. This determination method is used for determining whether a mixture of flammable dust and air is easily ignited by an electric discharge.

### Summary of Invention

### Technical Problem

However, it is difficult to divert this determination method to the purpose of determining the likelihood of occurrence of the disproportionation reaction in the refrigerant. The reason is that discharge is unlikely to occur in an environment in which a high pressure is applied to the refrigerant.

Therefore, in order to determine the likelihood of occurrence of the disproportionation reaction in a certain type of refrigerant, in other words, in order to determine the degree of the disproportionation reaction that has already occurred in a sample refrigerant, a discharging device capable of causing discharge in a high-pressure refrigerant is required.

### Solution to Problem

A discharging device according to a first aspect includes a first electrode and a second electrode, a capacitor, and a reactor unit. The first electrode and the second electrode are separated from each other. The capacitor stores energy to apply a first voltage between the first electrode and the second electrode. The reactor unit includes a first reactor and a second reactor. The reactor unit inductively generates a second voltage to be applied between the first electrode and the second electrode to start discharge of the energy between the first electrode and the second electrode.

According to this configuration, the reactor unit includes two reactors. Therefore, since the reactor unit can have a large reactance, the reactor unit can generate a large second voltage. Therefore, in a case where the high-pressure refrigerant is disposed between the first electrode and the second electrode, the discharge is started by the large induced voltage, which can cause the energy stored in the capacitor to be applied to the refrigerant. This enables evaluation of the disproportionation reaction in the refrigerant.

A discharging device according to a second aspect is the discharging device according to the first aspect, in which the first reactor includes a first reactor core made of ferrite and a first coil wound around the first reactor core. The second reactor includes a second reactor core made of ferrite and a second coil wound around the second reactor core.

According to this configuration, the material of the first reactor core and the second reactor core is ferrite. Therefore, it is easy to increase the second voltage.

A discharging device according to a third aspect is the discharging device according to the second aspect, in which each of the first reactor core and the second reactor core has a magnetic permeability of 250 H/m or more.

According to this configuration, the reactor cores have a large magnetic permeability. Therefore, it is easy to increase the second voltage.

A discharging device according to a fourth aspect is the discharging device according to the second aspect or the third aspect, in which each of the first coil and the second coil has a number of turns of 20 or more and 100 or less.

According to this configuration, the coils have a predetermined number of turns. Therefore, by cooperating with the ferrite cores, the coils can generate the large second voltage.

A discharging device according to a fifth aspect is the discharging device according to any one of the second aspect to the fourth aspect, in which each of the first coil and the second coil is made of a material selected from copper and silver.

According to this configuration, the material of the coils has low resistivity. Therefore, the energy loss can be reduced.

A discharging device according to a sixth aspect is the discharging device according to any one of the second aspect to the fifth aspect, further comprising a discharge path through which the energy is transmitted at a time of the discharge. The discharge path includes the capacitor, the first coil, and the second coil arranged in series. The discharge path does not include a semiconductor element.

According to this configuration, the discharge path does not include a semiconductor element. Therefore, since the discharge path can handle a large current exceeding a rated current of about several amperes of the semiconductor element, the discharge path can apply large energy to the refrigerant.

A discharging device according to a seventh aspect is the discharging device according to any one of the second aspect to the sixth aspect, in which the first reactor includes a first input coil wound around the first reactor core. The second reactor includes a second input coil wound around the second reactor core.

According to this configuration, by causing a current to flow through the first input coil and the second input coil, the second voltage can be induced.

A discharging device according to an eighth aspect is the discharging device according to any one of the first aspect to the seventh aspect, in which the second voltage is 20 kV or more and 100 kV or less.

According to this configuration, the second voltage has a large value. Therefore, since the discharging device can apply large discharge energy to the refrigerant, the magnitude of energy received by the refrigerant is stabilized.

A discharging device according to a ninth aspect is the discharging device according to any one of the first aspect to the eighth aspect, in which a current that flows through the first electrode or the second electrode is 50 A or more.

According to this configuration, the current involved in the discharge has a large value. Therefore, since the discharging device can apply large discharge energy to the refrigerant, the magnitude of energy received by the refrigerant is stabilized.

A discharging device according to a tenth aspect is the discharging device according to any one of the first aspect to the ninth aspect, in which each of the first electrode and the second electrode has a diameter of 3 mm or less.

According to this configuration, the electrodes have a small diameter. Therefore, since the first electrode and the second electrode have small volumes, thermal energy temporarily generated by the discharge is less likely to be cooled by a metal material forming the first electrode or the second electrode.

A discharging device according to an eleventh aspect is the discharging device according to any one of the first aspect to the tenth aspect, in which the first electrode and the second electrode are separated from each other by 10 µm or more.

According to this configuration, a large distance is maintained as a separation distance between the first electrode and the second electrode. Therefore, the magnitude of discharge energy received by the refrigerant is stabilized.

A discharging device according to a twelfth aspect is the discharging device according to any one of the first aspect to the eleventh aspect, in which the capacitor has a capacitance of 30 µF or more.

According to this configuration, the capacitor has a large capacitance. Therefore, since the discharging device can apply large discharge energy to the refrigerant, the magnitude of energy received by the refrigerant is stabilized.

A refrigerant evaluation device according to a thirteenth aspect includes a discharging device, a refrigerant chamber, a pressure sensor, and an arithmetic unit. The discharging device is the discharging device according to any one of the first aspect to the twelfth aspect. The refrigerant chamber has an internal space in which the first electrode and the second electrode are disposed. The internal space is capable of containing the refrigerant. The pressure sensor acquires a pressure of the refrigerant. The arithmetic unit calculates a degree of a disproportionation reaction in the refrigerant, based on an output of the pressure sensor. By the second voltage induced by the reactor unit being applied between the first electrode and the second electrode, the discharge of the energy is started in the refrigerant.

According to this configuration, the discharging device can apply large discharge energy to the refrigerant. Therefore, the refrigerant evaluation device can stably determine the degree of the disproportionation reaction in the refrigerant.

A refrigerant evaluation method according to a fourteenth aspect includes: preparing a refrigerant chamber having an internal space in which a first electrode and a second electrode are disposed; introducing a refrigerant into the internal space of the refrigerant chamber; acquiring a pressure of the refrigerant as a first pressure; storing energy in a capacitor to apply a first voltage between the first electrode and the second electrode; applying a second voltage induced by a reactor unit between the first electrode and the second electrode to start discharge of the energy in the refrigerant; applying the energy to the refrigerant at a time of the discharge; acquiring the pressure of the refrigerant as a second pressure; and calculating, based on the first pressure and the second pressure, a degree of a disproportionation reaction in the refrigerant.

According to this method, the degree of the disproportionation reaction in the refrigerant can be known.

A refrigerant evaluation method according to a fifteenth aspect is the refrigerant evaluation method according to the fourteenth aspect, in which the first electrode and the second electrode are separated from each other by 10 µm or more. Each of the first electrode and the second electrode has a diameter of 3 mm or less. A voltage between the first electrode and the second electrode at a time of the discharge is 20 kV or more and 100 kV or less. A current that flows through the first electrode or the second electrode is 50 A or more.

According to this method, the degree of the disproportionation reaction in the refrigerant can be stably known.

### Brief Description of Drawings

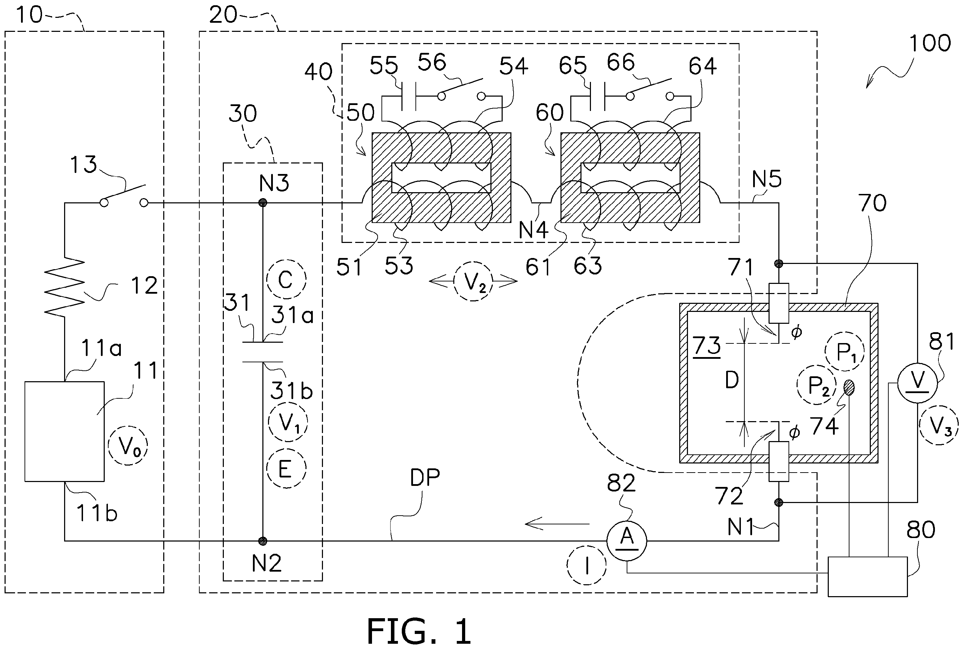

<Fig. 1> Fig. 1 is a schematic view illustrating a configuration of a refrigerant evaluation device 100.

### Description of Embodiments

### <Basic Embodiment>

### (1) Overall Configuration

Fig. 1 is a schematic view illustrating a configuration of the refrigerant evaluation device 100. The refrigerant evaluation device 100 is used for determining the likelihood of occurrence of a disproportionation reaction in a certain type of refrigerant, in other words, for determining the degree of the disproportionation reaction that has already occurred in a sample refrigerant. The refrigerant evaluation device 100 includes a refrigerant chamber 70, a charging device 10, a discharging device 20, and an arithmetic unit 80.

### (2) Detailed Configuration

### (2-1) Refrigerant Chamber 70

The refrigerant chamber 70 is a chamber having an internal space. The internal space is capable of containing a high-pressure refrigerant 73. The refrigerant 73 is a measurement target sample.

A first electrode 71 and a second electrode 72 are provided in the internal space of the refrigerant chamber 70. The first electrode 71 and the second electrode 72 cooperate with each other to cause discharge in the refrigerant 73. The first electrode 71 and the second electrode 72 are disposed to be separated from each other by a separation distance D. Each of the first electrode 71 and the second electrode 72 has a diameter ϕ.

A pressure sensor 74 for acquiring the pressure of the refrigerant 73 is disposed in the refrigerant chamber 70.

### (2-2) Charging Device 10

The charging device 10 is for accumulating energy E to be applied to the refrigerant 73 by discharge. The charging device 10 stores the energy E in a capacitor 31 of the discharging device 20, which will be described later.

The charging device 10 includes a DC power source 11, a resistor 12, and a charging switch 13.

The DC power source 11 has a positive terminal 11a and a negative terminal 11b, and outputs a DC voltage V₀ between the positive terminal 11a and the negative terminal 11b.

The resistor 12 is connected to at least one of the positive terminal 11a and the negative terminal 11b.

The charging switch 13 transmits the DC voltage V₀ output from the DC power source 11 to the capacitor 31 of the discharging device 20 or disconnects the DC voltage V₀ from the capacitor 31. As a result, the charging switch 13 charges the capacitor 31. The charging switch 13 may be, for example, a switch or a relay, which is a mechanical switching element, or may be a semiconductor element such as a power transistor.

### (2-3) Discharging Device 20

The discharging device 20 is for causing discharge between the first electrode 71 and the second electrode 72, thereby applying the energy E to the refrigerant 73.

The discharging device 20 includes an energy accumulation unit 30 and a reactor unit 40. The discharging device 20 does not include a semiconductor element.

The discharging device 20 include a discharge path DP. The discharge path DP extends from a node N1 connected to the second electrode 72 to a node N5 connected to the first electrode 71 via a node N2, a node N3, and a node N4. The discharge path DP does not include a semiconductor element such as a power transistor.

### (2-3-1) Energy Accumulation Unit 30

The energy accumulation unit 30 includes the capacitor 31. The capacitor 31 has a first terminal 31a and a second terminal 31b. The first terminal 3 1a is connected to the node N3. The second terminal 31b is connected to the node N2. The energy accumulation unit 30 does not include a semiconductor element such as a power transistor.

The node N3 is connected to the positive terminal 1 1a of the DC power source 11 via the resistor 12 and the charging switch 13. The node N2 is connected to the negative terminal 11b of the DC power source 11.

The capacitor 31 has a capacitance C. By the charging switch 13 being closed, the capacitor 31 is charged. As a result, the capacitor 31 accumulates an electric charge Q. Then, even when the charging switch 13 is opened, the capacitor 31 holds a first voltage V₁ between the first terminal 31a and the second terminal 31b by the action of the electric charge Q. At this time, the energy E stored in the capacitor 31 is expressed by the following equation: E = (1/2) × C × (V₁)².

When the discharge does not occur in the refrigerant chamber 70, the first voltage V₁ is applied between the first electrode 71 and the second electrode 72.

### (2-3-2) Reactor Unit 40

The reactor unit 40 is for starting discharge between the first electrode 71 and the second electrode 72. The reactor unit 40 inductively generates a large second voltage V₂. Even when the first voltage V₁ is applied between the first electrode 71 and the second electrode 72, while no discharge occurs, a current I does not flow between the first electrode 71 and the second electrode 72. In this state, by the large second voltage V₂ generated by the reactor unit 40 being applied between the first electrode 71 and the second electrode 72, plasma is generated in the refrigerant 73, and conduction occurs between the first electrode 71 and the second electrode 72. Then, the electric charge Q stored in the capacitor 31 moves between the first electrode 71 and the second electrode 72, thereby causing discharge in the refrigerant 73.

The reactor unit 40 includes a first reactor 50 and a second reactor 60. The first reactor 50 and the second reactor 60 are connected in series.

The first reactor 50 includes a first reactor core 51, a first primary coil 54, a first secondary coil 53, a first charging capacitor 55, and a first discharging switch 56. The material of the first reactor core 51 is ferrite. The first reactor core 51 has a magnetic permeability µ. The first primary coil 54 and the first secondary coil 53 are both wound around the first reactor core 51. The first secondary coil 53 has a number of turns N. The material of the first secondary coil 53 is selected from copper and silver. The first discharging switch 56 may be, for example, a switch or a relay, which is a mechanical switching element, or may be a semiconductor element such as a power transistor.

The second reactor 60 includes a second reactor core 61, a second primary coil 64, a second secondary coil 63, a second charging capacitor 65, and a second discharging switch 66. The material of the second reactor core 61 is ferrite. The second reactor core 61 has the magnetic permeability µ. The second primary coil 64 and the second secondary coil 63 are both wound around the second reactor core 61. The second secondary coil 63 has the number of turns N. The material of the second secondary coil 63 is selected from copper and silver. The second discharging switch 66 may be, for example, a switch or a relay, which is a mechanical switching element, or may be a semiconductor element such as a power transistor.

The first secondary coil 53 has one end connected to the node N3 and the other end connected to the node N4. The second secondary coil 63 has one end connected to the node N4 and the other end connected to the node N5. The reactor unit 40 does not include a semiconductor element such as a power transistor at least in the discharge path DP extending from the node N3 to the node N5.

The first charging capacitor 55 is charged by an unillustrated charging circuit. The first discharging switch 56 causes a transient current to flow through the first primary coil 54 by discharging the electric charge accumulated in the first charging capacitor 55. This transient current generates an induced voltage in the first secondary coil 53.

The second charging capacitor 65 is charged by an unillustrated charging circuit. The second discharging switch 66 causes a transient current to flow through the second primary coil 64 by discharging the electric charge accumulated in the second charging capacitor 65. This transient current generates an induced voltage in the second secondary coil 63.

The large second voltage V₂ is generated by the induced voltages of the plurality of coils, which are the first secondary coil 53 and the second secondary coil 63.

### (2-4) Arithmetic Unit 80

The arithmetic unit 80 is a computer including a central processing unit and a storage device. The arithmetic unit 80 calculates the degree of the disproportionation reaction in the refrigerant 73, based on at least the output of the pressure sensor 74.

The arithmetic unit 80 may further use outputs of a voltmeter 81 and an ammeter 82 to calculate the degree of the disproportionation reaction in the refrigerant 73. The voltmeter 81 measures a third voltage V₃, which is a potential difference between the first electrode 71 and the second electrode 72. The ammeter 82 measures the current I flowing through the first electrode 71 or the second electrode 72. The ammeter 82 is disposed, for example, in a section sandwiched between the node N1 and the node N2. The ammeter 82 has almost no resistance to be applied to the discharge path DP. Therefore, it may be considered that there is no semiconductor element caused by the ammeter 82 in the section sandwiched between the node N1 and the node N2.

The arithmetic unit 80 may perform control to open and close at least one of the charging switch 13, the first discharging switch 56, and the second discharging switch 66.

### (3) Parameters

The pressure of the refrigerant 73 contained in the refrigerant chamber 70 is set to, for example, 1 MPa or more and 10 MPa or less.

The first voltage V₁ is, for example, 100 V or more and 2000 V or less.

The second voltage V₂ is, for example, 20 kV or more and 100 kV or less.

The third voltage V₃ is, for example, 20 kV or more and 100 kV or less.

The current I generated by discharge is, for example, 50 A or more.

The diameter ϕ of each of the first electrode 71 and the second electrode 72 is, for example, 3 mm or less. Preferably, the diameter ϕ is 1 mm or less. More preferably, the diameter ϕ is 0.5 mm or less.

The separation distance D between the first electrode 71 and the second electrode 72 is, for example, 10 µm or more.

The capacitance C is, for example, 30 µF or more.

The magnetic permeability µ of each of the first reactor core 51 and the second reactor core 61 is, for example, 250 H/m or more.

The number of turns N of each of the first secondary coil 53 and the second secondary coil 63 is, for example, 20 or more and 100 or less.

The energy E is, for example, 1 mJ or more and 5000 J or less. Preferably, the energy E is 1 mJ or more and 2500 J or less.

### (4) Procedure to Evaluate Refrigerant

The procedure to evaluate the refrigerant 73 includes the following steps.

In a first step, the refrigerant 73 is introduced into the internal space of the refrigerant chamber 70.

In a second step, the arithmetic unit 80 acquires the pressure of the refrigerant 73 as a first pressure P₁.

In a third step, the capacitor 31 is charged by temporarily closing the charging switch 13. This causes the first voltage V₁ held by the capacitor 31 to be applied between the first electrode 71 and the second electrode 72. However, discharge is yet to occur in the refrigerant 73.

In a fourth step, the reactor unit 40 inductively generates the second voltage V₂ by simultaneously closing the first discharging switch 56 and the second discharging switch 66. The second voltage V₂ is applied between the first electrode 71 and the second electrode 72.

In a fifth step, plasma is generated in the refrigerant 73 by the second voltage V₂, and thus, conduction occurs between the first electrode 71 and the second electrode 72.

In a sixth step, the electric charge Q accumulated in the capacitor 31 flows between the first electrode 71 and the second electrode 72, and thus, discharge is started in the refrigerant 73.

In a seventh step, the arithmetic unit 80 acquires the pressure of the refrigerant 73 as a second pressure P₂.

In an eighth step, the arithmetic unit 80 calculates the degree of the disproportionation reaction in the refrigerant 73, based on the first pressure P₁ and the second pressure P₂. When the refrigerant 73 obtains the energy E from the discharge, a chemical reaction occurs in the refrigerant 73, which causes a change in the number of molecules of the refrigerant 73. The number of molecules of the refrigerant 73 is acquired as a pressure value by the pressure sensor 74. The change in the number of molecules varies depending on the number of refrigerant molecules that can react and that the refrigerant 73 contained in the internal space of the refrigerant chamber 70 initially has. Therefore, based on the first pressure P₁ and the second pressure P₂, the number of refrigerant molecules that can react and that the refrigerant 73 has when being introduced into the refrigerant chamber 70 is calculated. The number of refrigerant molecules that can react is treated as an index indicating the degree of the disproportionation reaction that has already occurred in the refrigerant 73.

Note that this index may be calibrated by the magnitude of the energy E that the refrigerant 73 has obtained from discharge. The magnitude of energy may be calculated from the third voltage V₃ measured by the voltmeter 81 and the current I measured by the ammeter 82.

### (5) Features

(5-1)
The reactor unit 40 includes two reactors, which are the first reactor 50 and the second reactor 60. Therefore, since the reactor unit 40 can have a large reactance, the reactor unit 40 can generate the large second voltage V₂. Therefore, in a case where the high-pressure refrigerant 73 is disposed between the first electrode 71 and the second electrode 72, discharge is started by the second voltage V₂, which is the large induced voltage, which can cause the energy E stored in the capacitor 31 to be applied to the refrigerant 73. This enables evaluation of the disproportionation reaction in the refrigerant 73.

Under the condition that the refrigerant 73 is maintained at a high pressure, discharge due to dielectric breakdown is less likely to occur. In order to perform discharge in the high-pressure refrigerant 73, it is necessary to generate plasma in the refrigerant by applying a large voltage to the refrigerant 73. In the present invention, by using the two reactors, the large second voltage V₂ can be induced. Therefore, discharge due to dielectric breakdown can occur in the high-pressure refrigerant 73.

(5-2)
The material of the first reactor core 51 and the second reactor core 61 is ferrite. Therefore, it is easy to increase the second voltage V₂.

(5-3)
The first reactor core 51 and the second reactor core 61 have the large magnetic permeability µ. Therefore, it is easy to increase the second voltage V₂.

(5-4)
The first secondary coil 53 and the second secondary coil 63 have the predetermined number of turns. Therefore, by cooperating with the first reactor core 51 and the second reactor core 61, the first secondary coil 53 and the second secondary coil 63 can generate the large second voltage V₂.

(5-5)
The material of the first secondary coil 53 and the second secondary coil 63 has low resistivity. Therefore, the loss of the energy E can be reduced.

(5-6)
The discharge path DP does not include a semiconductor element. Therefore, since the discharge path DP can handle a large current exceeding a rated current of about several amperes of the semiconductor element, the discharge path DP can apply the large energy E to the refrigerant 73.

By increasing the magnitude of the energy E applied to the refrigerant 73, the magnitude of the energy E is stabilized, and thus, the reproducibility of the disproportionation reaction occurring in the refrigerant 73 is improved. Therefore, for the specific refrigerant 73, the likelihood of occurrence of the disproportionation reaction can be accurately evaluated.

Furthermore, by changing the magnitude of the energy E applied to the refrigerant 73 over a wide range, it is possible to further improve the accuracy of the evaluation of the likelihood of occurrence of the disproportionation reaction for the specific refrigerant 73. For example, the magnitude of the energy E may be changed from the order of several millij oules (mJ) to the order of several thousand joules (J).

(5-7)
By causing a current to flow through the first primary coil 54 and the second primary coil 64, the second voltage V₂ can be induced.

(5-8)
The value of the second voltage V₂ is large. Therefore, since the discharging device 20 can apply the large energy E to the refrigerant 73, the magnitude of the energy E received by the refrigerant 73 is stabilized.

(5-9)
The value of the current I involved in discharge is large. Therefore, since the discharging device 20 can apply the large energy E to the refrigerant 73, the magnitude of the energy E received by the refrigerant 73 is stabilized.

(5-10)
The diameter ϕ of the first electrode 71 and the second electrode 72 is small. Therefore, since the first electrode 71 and the second electrode 72 have small volumes, thermal energy temporarily generated by discharge is less likely to be cooled by a metal material forming the first electrode 71 or the second electrode 72.

(5-11)
A large distance can be maintained as the separation distance D between the first electrode 71 and the second electrode 72. Therefore, the magnitude of the energy E received by the refrigerant 73 is stabilized.

(5-12)
The capacitance C of the capacitor 31 is large. Therefore, since the discharging device 20 can apply the large energy E to the refrigerant 73, the magnitude of the energy E received by the refrigerant 73 is stabilized.

(5-13)
The discharging device 20 can apply the large energy E to the refrigerant. Therefore, the refrigerant evaluation device 100 can stably determine the degree of the disproportionation reaction in the refrigerant 73.

### <Modification Examples of Basic Embodiment>

### (6) Modification Examples

(6-1) First Modification Example

In the above-described embodiment, in the charging device 10, the resistor 12 and the charging switch 13 are both connected to the positive terminal 11a of the DC power source 11. Alternatively, at least one of the resistor 12 and the charging switch 13 may be connected to the negative terminal 11b of the DC power source 11.

(6-2) Second Modification Example

In the above-described embodiment, the reactor unit 40 is connected between the node N3 and the node N5, which are present on the side of the positive terminal 1 1a of the DC power source 11. Alternatively, the reactor unit 40 may be connected between the node N1 and the node N2, which are present on the side of the negative terminal 11b of the DC power source 11.

### <Conclusion>

Although the embodiment of the present disclosure has been described above, it should be understood that various changes can be made on the forms and details without departing from the spirit and scope of the present disclosure described in the claims.

### Reference Signs List

- 10: charging device
- 20: discharging device
- 30: energy accumulation unit
- 31: capacitor
- 40: reactor unit
- 50: first reactor
- 51: first reactor core
- 53: first secondary coil (first coil)
- 54: first primary coil (first input coil)
- 60: second reactor
- 61: second reactor core
- 63: second secondary coil (second coil)
- 64: second primary coil (second input coil)
- 70: refrigerant chamber
- 71: first electrode
- 72: second electrode
- 73: refrigerant
- 74: pressure sensor
- 80: arithmetic unit
- 100: refrigerant evaluation device
- C: capacitance
- D: separation distance
- DP: discharge path
- E: energy
- I: current
- N: number of turns
- P₁: first pressure
- P₂: second pressure
- Q: electric charge
- V₀: DC voltage
- V₁: first voltage
- V₂: second voltage
- V₃: third voltage
- ϕ: diameter
- µ: magnetic permeability

### Citation List

### Non Patent Literature

NPL 1: Japanese Industrial Standard (JIS) Z 8834

## Claims

1. A discharging device (20) comprising:
a first electrode (71) and a second electrode (72) separated from each other;
a capacitor (31) configured to store energy (E) to apply a first voltage (V₁) between the first electrode and the second electrode; and
a reactor unit (40) comprising a first reactor (50) and a second reactor (60) and configured to inductively generate a second voltage (V₂) to be applied between the first electrode and the second electrode to start discharge of the energy between the first electrode and the second electrode.

2. The discharging device according to claim 1, wherein
the first reactor comprises a first reactor core (51) made of ferrite and a first coil (53) wound around the first reactor core, and
the second reactor comprises a second reactor core (61) made of ferrite and a second coil (63) wound around the second reactor core.

3. The discharging device according to claim 2, wherein
each of the first reactor core and the second reactor core has a magnetic permeability (µ) of 250 H/m or more.

4. The discharging device according to claim 2 or 3, wherein
each of the first coil and the second coil has a number of turns (N) of 20 or more and 100 or less.

5. The discharging device according to any one of claims 2 to 4, wherein
each of the first coil and the second coil is made of a material selected from copper and silver.

6. The discharging device according to any one of claims 2 to 5, further comprising a discharge path (DP) through which the energy is transmitted at a time of the discharge, wherein
the discharge path comprises the capacitor, the first coil, and the second coil arranged in series, and
the discharge path does not comprise a semiconductor element.

7. The discharging device according to any one of claims 2 to 6, wherein
the first reactor comprises a first input coil (54) wound around the first reactor core, and
the second reactor comprises a second input coil (64) wound around the second reactor core.

8. The discharging device according to any one of claims 1 to 7, wherein
the second voltage (V₂) is 20 kV or more and 100 kV or less.

9. The discharging device according to any one of claims 1 to 8, wherein
a current (I) that flows through the first electrode or the second electrode is 50 A or more.

10. The discharging device according to any one of claims 1 to 9, wherein
each of the first electrode and the second electrode has a diameter (φ) of 3 mm or less.

11. The discharging device according to any one of claims 1 to 10, wherein
the first electrode and the second electrode are separated from each other by 10 µm or more.

12. The discharging device according to any one of claims 1 to 11, wherein
the capacitor has a capacitance (C) of 30 µF or more.

13. A refrigerant evaluation device (100) comprising:
the discharging device (20) according to any one of claims 1 to 12;
a refrigerant chamber (70) capable of containing a refrigerant (73) in an internal space in which the first electrode and the second electrode are disposed;
a pressure sensor (74) configured to acquire a pressure of the refrigerant; and
an arithmetic unit (80) configured to calculate a degree of a disproportionation reaction in the refrigerant, based on an output of the pressure sensor, wherein
by the second voltage induced by the reactor unit being applied between the first electrode and the second electrode, the discharge of the energy is started in the refrigerant.

14. A refrigerant evaluation method comprising:
preparing a refrigerant chamber (70) having an internal space in which a first electrode (71) and a second electrode (72) are disposed;
introducing a refrigerant (73) into the internal space of the refrigerant chamber;
acquiring a pressure of the refrigerant as a first pressure (P₁);
storing energy (E) in a capacitor (31) to apply a first voltage (V₁) between the first electrode and the second electrode;
applying a second voltage (V₂) induced by a reactor unit (40) between the first electrode (71) and the second electrode (72) to start discharge of the energy in the refrigerant;
applying the energy to the refrigerant at a time of the discharge;
acquiring the pressure of the refrigerant as a second pressure (P₂); and
calculating, based on the first pressure and the second pressure, a degree of a disproportionation reaction in the refrigerant.

15. The refrigerant evaluation method according to claim 14, wherein
the first electrode and the second electrode are separated from each other by 10 µm or more;
each of the first electrode and the second electrode has a diameter (φ) of 3 mm or less;
a voltage (V₃) between the first electrode and the second electrode at a time of the discharge is 20 kV or more and 100 kV or less; and
a current (I) that flows through the first electrode or the second electrode is 50 A or more.
